(12) EUROPEAN PATENT SPECIFICATION

(45) Date of publication and mention
of the grant of the patent:
25.08.1999 Bulletin 1999/34

(51) Int Cl.⁶: $H01L\ 21/31$, $G03F\ 7/26$

(21) Application number: 87107743.4

(22) Date of filing: 27.05.1987

(54) **A method for stripping a photo resist on an aluminium alloy**

Eine Methode, um einen Photolack von einer Aluminiumlegierung zu entfernen

Méthode pour enlever une résine photosensible sur un alliage d'aluminium

(84) Designated Contracting States:
DE FR GB

(30) Priority: 29.05.1986 JP 12412386

(43) Date of publication of application:
02.12.1987 Bulletin 1987/49

(73) Proprietor: FUJITSU LIMITED
Kawasaki-shi, Kanagawa 211 (JP)

(72) Inventor: Nakamura, Moritaka
c/o FUJITSU LIMITED
Nakahara-ku Kawasaki-shi Kanagawa 211 (JP)

(74) Representative: Greenstreet, Cyril Henry et al
Haseltine Lake & Co.
Imperial House
15-19 Kingsway
London WC2B 6UD (GB)

(56) References cited:
EP-A- 0 010 138          US-A- 4 370 195

- PATENT ABSTRACTS OF JAPAN, vol. 5, no. 117 (E-67)[789], 28th July 1981; & JP-A-56 55 050 (FUJITSU K.K.) 15-05-1981
- PATENT ABSTRACTS OF JAPAN, vol. 8, no. 81 (E-238)[1518], 13th April 1984; & JP-A-59 3927 (FUJITSU K.K.) 10-01-1984
- PATENT ABSTRACTS OF JAPAN, vol. 9, no. 47 (E-299)[1770], 27th February 1985; & JP-A-59 186 326 (HITACHI SEISAKUSHO K.K.) 23-10-1984
- IBM TECHNICAL DISCLOSURE BULLETIN, vol. 21, no. 6, November 1978, page 2315, New York, US; G.T. CHIU et al.: "Plasma removal of residue following reactive ion etching of aluminum and aluminum alloys"

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

A method for stripping a photo resist on an aluminum alloy.

This invention relates to a method for stripping a photo resist coated on a layer of an aluminum alloy, such as aluminum-copper, formed on a semiconductor substrate.

Aluminum or aluminum-silicon alloy containing several percent of silicon has been generally used for an interconnection layer on a semiconductor device. However, it is also well known that the interconnection layer may be broken by electromigration, particularly in a semiconductor device where a very fine interconnection is required, such as 4 μm for a high speed ECL (Emitter Coupled Logic) or 1 μm for MOS (Metal Oxide Semiconductor), to achieve a greater density of integration, and a correspondingly higher density of the current flowing therethrough is required. In order to prevent this electromigration of the interconnection layer, an aluminum-copper alloy containing 2 to 4% of copper has come to be used, particularly where a high current-density is handled as in a bipolar device or a high-speed logic circuit. However, the aluminum-copper alloy suffers from problems due to residual chlorine therein.

When an aluminum or aluminum alloy layer is plasma dry-etched by chlorinated gases, such as a mixture of chlorine (referred to hereinafter as $Cl_2$) with silicon tetrachloride ($SiCl_4$) or boron trichloride ($BCl_3$), the residual chlorine problem arises as follows:

$$Al + Cl^* \rightarrow AlCl_3{\uparrow}, Al_2Cl_6{\uparrow}$$

where $Cl^*$ denotes a chlorine radical produced in the plasma, and $\uparrow$ denotes sublimation. The aluminum, Al, reacts with $Cl^*$ to produce $AlCl_3$ or $Al_2Cl_6$, which then sublimes, and the aluminum continues to be etched in this way. When the etch-processed substrate is brought out into the open air, the $AlCl_3$, etc., which has sublimed and deposited on a surface of the side wall of the aluminum layer or on a photo resist reacts with atmospheric water, because the $AlCl_3$ is deliquescent. Hydrochloric acid (HCl) is thus produced thereon as shown by the following equation:

$$AlCl_3 + 3\,H_2O \rightarrow 3\,HCl + Al(OH)_3.$$

The HCl then reacts with the Al to produce $AlCl_3$ again as follows:

$$Al + 3\,HCl \rightarrow AlCl_3 + \tfrac{1}{2}\,H_2O.$$

Thus, the reactions are continued repeatedly. In other words, the corrosion of the aluminum layer continues indefinitely. In order to prevent this corrosion, one or more of the following procedures is or are carried out for aluminum, aluminum-titanium (Al-Ti) alloy or aluminum-silicon (Al-Si) alloy, after the dry etching process:

(1) Stripping the photo resist without exposing the substrate to the open air so as to prevent the chlorine deposit on the substrate from reacting with the water content in the open air.
(2) Drying the substrate with a hot nitrogen gas blast at up to 100 to 200°C, and then washing it with water so as to remove the residual chlorine.
(3) Washing the substrate with water, and then baking it in an oxygen atmosphere at approximately 350°C so as to remove the residual chlorine.
(4) Plasma-processing the substrate in a fluorinated gas, such as $CF_4$, $SF_6$ or $CHF_3$, so as to replace the residual chlorine atoms by the fluorine atoms produced in the plasma. A stable aluminum fluoride (AlF or $AlF_3$) is thus formed over the aluminum surface to prevent the chlorine component from reacting with water contained in the air.
(5) Plasma-processing the substrate in hydrogen gas, which reacts with the residual chlorine component to produce hydrogen chloride.

By the application of the above-mentioned procedures the residual chlorine component on the substrate made of the above-mentioned aluminum or aluminum alloys can be removed, and thus the corrosion can be prevented. However, when an aluminum alloy, such as aluminum-copper (Al-Cu) or aluminum-copper-silicon (Al-Cu-Si) is etched, its chlorine component remains in the form of $Cu_xCl_y$ or a mixture of Cu, Cl, Al and carbon from the photo resist, which are difficult to remove as they have much higher sublimation temperatures than aluminum chloride, and may therefore cause corrosion even after the above-described chlorine-removal processing is carried out.

Patent Abstracts of Japan, Vol. 9, No. 47, (E-299) [1770], 1985, and JP-A-59 186326, disclose direct oxygen ashing of resist films on aluminum wiring which has been plasma etched, removing chlorine compounds in the resist films.

IBM Technical Disclosure Bulletin, Vol. 21, No. 6, November 1978, page 2315, discloses reactive ion etching of aluminum/copper metallurgy using a chlorine containing gas. To remove a residue the metallurgy, after etching, is placed in a highly oxidising plasma using a gas mixture of about 10% $CF_4$ and 90% $O_2$.

US-A-4 370 195 discloses etching of aluminum (and also mentions aluminum alloys) using a carbon-containing etchant gas. It is disclosed that the particular residues remaining after such etching cannot be removed by direct oxygen ashing. The use of a nitrogen glow discharge to remove the residues is taught.

EP-A-0 140 755 discloses an apparatus and a method for downstream plasma etching, which can be employed for oxygen ashing.

EP-A-0 010 138 discloses the treatment of aluminium and aluminium alloy microcircuits by heating in an oxygen atmosphere at a temperature of 200 - 450°C.

To overcome the problems mentioned above an improved method of removing the residual chlorine is desirable.

It is an object of the invention to provide a method that may be used to form a pattern of an aluminum alloy on a semiconductor substrate without corrosion problems caused by residual chlorine on the substrate.

According to the present invention there is provided a method for forming an aluminum alloy pattern on a semiconductor substrate, comprising the steps of:

forming a layer of aluminium alloy that reacts with chlorine to form a residual chlorine component having a sublimation temperature higher than that of aluminum chloride on a semiconductor substrate having an insulation layer thereon;

forming a resist pattern on said aluminum alloy layer;

dry etching an exposed portion of said aluminum alloy layer with a gas containing chlorine, chosen from the group of chlorine gas, silicon tetrachloride gas, boron trichloride gas and carbon tetrachloride gas, using said resist pattern as a mask, whereby said aluminum alloy layer is patterned and said residual-chlorine component remains on the substrate;

generating a gas plasma of a reaction gas containing an oxygen gas by applying electromagnetic power to a plasma generating chamber;

introducing reactive species, generated in said gas plasma, from said plasma generating chamber via holes in a wall forming a part of said plasma generating chamber, towards the semiconductor substrate, whereby said wall essentially shields the semiconductor substrate from said electromagnetic power, to provide an atmosphere containing said reactive species;

stripping said resist pattern in said atmosphere containing reactive species; and

heating the substrate in a vacuum at a temperature higher than 100°C but low enough to avoid damage to the aluminum alloy, whereby said residual chlorine component is removed from the substrate said heating step being carried out concurrently with said stripping step or after said stripping step.

In an embodiment of the invention, the method includes the steps of: forming a layer of aluminum-copper alloy on a semiconductor substrate; forming a resist pattern on said alloy layer; etching said alloy layer by the use of said resist pattern in a chlorinated gas plasma so as to form an alloy pattern; downstream stripping said resist pattern in an atmosphere containing a reactive species; and heating the thus-processed substrate in a vacuum at a temperature higher than 100°C, to remove the residual chlorine component. The stripping process and the heating process may be combined; that is to say, be carried out concurrently.

The above-mentioned features and advantages of the present invention, together with other objects and advantages, which will become apparent, will be more fully described hereinafter with reference to the accompanying drawings, in which like numerals refer to like parts throughout.

Figs. 1(a) to 1(d) are sectional views that schematically illustrate the main part of a semiconductor device at successive steps of a fabrication process according to the present invention.

Fig. 2 schematically illustrates a dry processing apparatus using microwave power, used for the stripping step of the present invention.

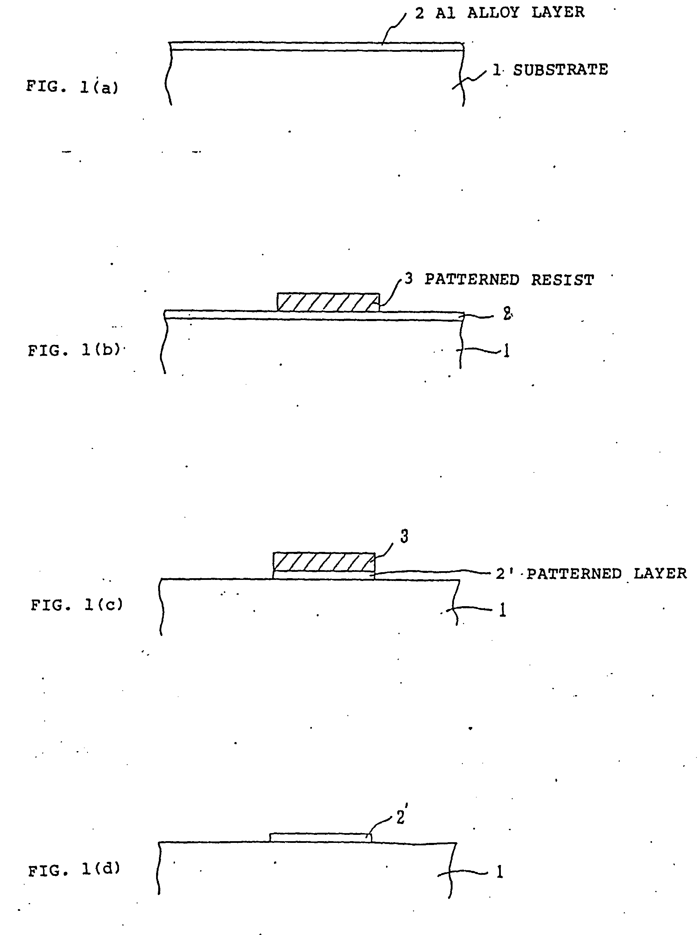

Referring now to Figs. 1(a) to 1(d), the fabrication steps in a preferred embodiment of the present invention are as follows:

By general fabrication methods (not shown in the Figures) a semiconductor substrate 1 is fabricated with IC devices therein and coated with an insulation film thereon, for example of PSG (phospho silicate glass).

A layer 2 of an aluminum-copper alloy, for example Al-Cu(4%) up to approximately 8000Å thick is formed all over the semiconductor substrate 1 by a known general method, such as sputtering, as shown in Fig. 1(a). A photo resist film is formed upon the alloy layer 2, and the resist film is patterned, as denoted by 3 in Fig. 1(b), by a known general lithography technique. The exposed portion of the alloy layer 2, i.e. the portion not masked by the photo resist pattern 3, is removed by a known general dry etching method. The dry etching may be a reactive ion etching method using as etching agent an etching gas such as a mixture of chlorine ($Cl_2$) gas (24 sccm (standard cubic centimeter per minute)) and silicon tetrachloride ($SiCl_4$) gas (40 sccm). The gas pressure is reduced to approximately 0.02 Torr (2.67 Pa), and radio frequency power of 13.56 MHz, for example, and 250 W, for example, is applied thereto for 5 minutes, for example, by well known methods. The etching gas is dissociated in a glow discharge driven by the applied radio frequency power and the chlorine atoms produced are active to react with the aluminum as well as the copper of the alloy. The aluminum chloride sublimes in the same manner as explained in the description of the prior art, and the copper chloride is sputtered by the energetic ion bombardment, so that the exposed portion of the alloy is etched and removed leaving the patterned layer 2', as shown in Fig. 1(c). Next, the substrate 1 is transferred to a dry processing apparatus for stripping the patterned photo resist 3, passing through a vacuum system or an inert gas purged system, in order to avoid being exposed to the atmosphere. If the substrate is exposed to the atmosphere, the residual chlorine on the substrate reacts with water contained in the air and corrodes the alloy, as explained in the prior art.

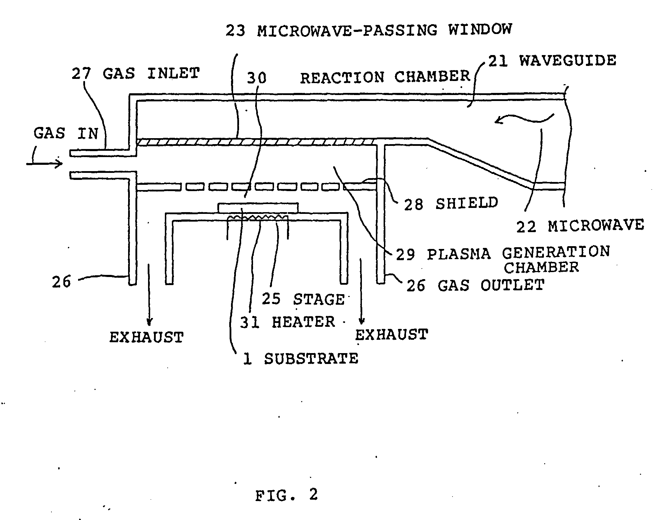

The patterned photo resist 3 on the patterned alloy layer 2' is then stripped by a known downstream etching method. A stripping apparatus using microwave power, which is preferably employed in this stripping step, and is also called a downstream ashing or an after-glow ashing, will be described in detail later. As a reaction gas in the dry etching, a mixture of a $CF_4$ gas (100 sccm) and oxygen ($O_2$) gas (1500 sccm), for example, is used at approximately 1 Torr (1.33 x $10^2$ Pa), and microwave power of 2.45 GHz and 1 KW is applied thereto for 2 minutes, for example, while the substrate is kept at room temperature, such as 30°C. After finishing this stripping process, the substrate is heated so that the residual chlorine component is baked out. In the apparatus shown in Fig.2 the heating is effected by the electric heater 31 built in the stage 25 to approximately 300°C for 2 minutes for example while the apparatus is pumped out to 0.2-0.3 Torr (0.27-0.4 x $10^2$ Pa). After the substrate is cooled enough, the substrate is brought out of the apparatus, thus the processes of the invention are all finished. This method will be referred to as method I. It is also possible to heat the substrate on a separate heating stage from the stripping stage 25 in the vacuum chamber in order to save the cycle time for heating/cooling the massive stage.

The last baking process of method I may be combined with the stripping process. In other words, these two processes can be carried out concurrently. In this case, the stripping process is carried out while the substrate 1 is heated to 200 to 300°C by an electric heater 31 mounted in the stage 25. This method will be referred to as method II.

When the stripping and baking processes are combined as in method II, the etching gas may be a mixture of nitrogen ($N_2$) gas (100 sccm) and oxygen ($O_2$) gas (1500 sccm) at approximately 1 Torr (1.33 x $10^2$ Pa), and the substrate may be heated at 200 to 300°C. This method will be referred to as method III.

In these methods, the combination of the heating and the downstream stripping is essential, because heating without stripping cannot remove the residual chlorine components under 400°C. Moreover, conventional plasma stripping causes a particle problem by $Al_2O_3$ formation.

In order to confirm the effect of the above-described methods of the present invention, the processed substrate was exposed to the atmosphere for 2 days. The alloy pattern was then optically observed to check for corrosion, and the residual chlorine atoms were measured by X-ray fluorescence spectroscopy. The check results are set out in the following table, in which

(a) shows the temperature of the substrate during the heating, in °C,
(b) shows existence of the corrosion found by optical observation using a microscope of magnification x 1000, and
(c) shows the amount of residual chlorine atoms in units of cps (counts per second), where 10-cps corresponds to 1.64 x $10^4$ atoms per $cm^2$.

| Method | I | II | II | II | II | II | III |
|---|---|---|---|---|---|---|---|
| (a) | 300 | 30 | 70 | 110 | 150 | 200 | 300 |
| (b) | no | yes | yes | no | no | no | no |
| (c) | 8.1 | 141.1 | 122.2 | 21.4 | 11.6 | 9.5 | 8.3 |

As seen in the Table, when the substrate is heated at above 100°C, the residual chlorine is evidently reduced and no corrosion is observed. The amount of residual chlorine is reduced as the heating temperature is raised, but on the other hand, if the temperature exceeds 300°C, the aluminum is affected: for example hillocks are formed on the surface of the aluminum. Therefore, the temperature must be lower than 400°C, and preferably be chosen between 250 and 300°C.

An embodiment of the dry etching apparatus for stripping the photo resist will now be described in detail, with reference to Fig. 2. The apparatus employs microwave power for producing reactive species as etching agent. The substrate 1 is loaded on the stage 25 in a reaction chamber 30. In the stage 25, an electric heater 31 and a thermometer (not shown in the Figure) are mounted to heat the substrate when required. The chamber 30 is evacuated through gas outlets 26 by conventional evacuation equipment, which is not shown in the Figure. An etching gas is introduced into the chamber 30 through the gas inlet 27. By balancing the gas evacuation and gas introduction, the gas pressure within the chamber 30 is controlled to obtain the required gas pressure. A microwave-passing window 23 made of an insulating material, such as quartz or alumina, is installed perpendicularly to the electric field in the wave guide 21 and also seals the vacuum of the chamber 30. A metal shield plate 28 having many small holes therein shields the microwaves from the reaction chamber 30, so that a plasma generation chamber 29 is formed between the microwave-passing window 23 and the shield plate 28. Microwave power 22 is fed through the wave guide 21 and through the microwave-passing window 23 into the plasma generation chamber 29. In the plasma generation chamber 29, the etching gas is made into plasma by the excitation by the microwave power. A reactive species, such as oxygen atoms, produced in the plasma comes out through the holes of the shield plate 28 and flows directly down on to the substrate 1, i.e. efficiently, because the shield plate is located close to the substrate 1. This reactive species is very reactive with the photo resist on the substrate, but does not harm the substrate by an ionic bombardment as in the plasma etching because the species coming out of the holes of the shield plate 28 is not ionic and no other ionic gas comes out at all. Therefore, this type of apparatus is advantageously employed for stripping the photo resist.

Although aluminum-copper alloy is referred to in the above-described embodiment as the material to be processed, the present invention is also effective for other alloys such as AlCuSi and AlSiTiCu.

Although a mixture of $Cl_2$ and $SiCl_4$ is referred to as an etching gas for etching the alloy in the above-described embodiment, other gases of chlorine family, such as $BCl_3$, $CCl_4$ and $CHCl_3$, can be also used therein, as is well known.

Although a dry etching apparatus using a radio frequency of 13.56 MHz is referred to in the above-described embodiment for etching the alloy, other types of dry etching apparatus, for example using a radio frequency of 400 KHz, can also be used, as is well known.

Although a mixture of $CF_4$, $N_2$ and $O_2$ is referred to as an etching gas for stripping the photo resist in the above-described embodiment, other fluorinated gases, such as $CHF_3$, $C_2F_6$, $SF_6$, $NF_3$ or $CBrF_3$, can be also used, singly or mixed, in place of $CF_4$, and other nitrogen-containing gases, such as $N_2O$ or $NO_2$, can be also used in place of $N_2$, as is well known.

Although a dry etching apparatus using a microwave frequency of 2.45 GHz is referred to in the above-described embodiment for stripping the photo resist, other types of dry etching apparatus, e.g. using a radio frequency of 13.56 MHz, can also be used, as is well known.

## Claims

1. A method for forming an aluminum alloy pattern on a semiconductor substrate, comprising the steps of:

   forming a layer of aluminum alloy (2) that reacts with chlorine to form a residual chlorine component having a sublimation temperature higher than that of aluminum chloride on a semiconductor substrate (1) having an insulation layer thereon;
   forming a resist pattern (3) on said aluminum alloy layer (2);
   dry etching an exposed portion of said aluminum alloy layer (2) with a gas containing chlorine, chosen from the group of chlorine gas, silicon tetrachloride gas, boron trichloride gas and carbon tetrachloride gas, using said resist pattern (3) as a mask, whereby said aluminum alloy layer (2) is patterned and said residual chlorine component remains on the substrate;
   generating a gas plasma of a reaction gas containing an oxygen gas by applying electromagnetic power to a plasma generating chamber (29);
   introducing reactive species, generated in said gas plasma, from said plasma generating chamber (29) via holes in a wall (28) forming a part of said plasma generating chamber, towards the semiconductor substrate (1), whereby said wall (28) essentially shields the semiconductor substrate (1) from said electromagnetic power, to provide an atmosphere containing said reactive species;
   stripping said resist pattern (3) in said atmosphere containing reactive species; and
   heating the substrate (1) in a vacuum at a temperature higher than 100°C but low enough to avoid damage to the aluminum alloy, whereby said residual chlorine component is removed from the substrate, said heating step being carried out concurrently with said stripping step or after said stripping step.

2. A method according to claim 1, wherein the temperature in said heating step is lower than approximately 400°C.

3. A method according to claim 1 or claim 2, wherein said reactive species is or are produced from a mixture of a fluorinated gas and oxygen gas.

4. A method according to any one of claims 1 to 3, wherein said reactive species is or are produced from a mixture of a nitrogen-containing gas and oxygen gas.

5. A method according to any preceding claim, wherein said reactive species is or are produced by excitation by microwave power of approximately 2.45 GHz.

6. A method according to any preceding claim, wherein said aluminum alloy is an aluminum-copper alloy.

**Patentansprüche**

1. Verfahren zum Bilden eines Aluminiumlegierungsmusters auf einem Halbleitersubstrat, mit den folgenden Schritten:

Bilden einer Schicht aus einer Aluminiumlegierung (2), die mit Chlor reagiert, um eine Restchlorkomponente zu bilden, die eine höhere Sublimationstemperatur als Aluminium-chlorid hat, auf einem Halbleitersubstrat (1), auf dem eine Isolierschicht vorhanden ist;
Bilden eines Resistmusters (3) auf der Aluminiumlegierungsschicht (2);
Trockenätzen eines exponierten Abschnittes der Aluminiumlegierungsschicht (2) mit einem chlorhaltigen Gas, das ausgewählt ist aus der Gruppe aus Chlorgas, Siliziumtetrachloridgas, Bortrichloridgas und Kohlenstofftetrachloridgas, unter Verwendung des Resistmusters (3) als Maske, wodurch die Aluminiumlegierungsschicht (2) gemustert wird und die Restchlorkomponente auf dem Substrat zurückbleibt;
Erzeugen eines Gasplasmas aus einem Reaktionsgas, das ein Sauerstoffgas enthält, durch Anwenden von elektromagnetischer Energie auf eine Plasmaerzeugungskammer (29);
Leiten von reaktionsfähigen Arten, die in dem Gasplasma erzeugt werden, aus der Plasmaerzeugungskammer (29) durch Löcher in einer Wand (28), die einen Teil der Plasmaerzeugungskammer bildet, hin zu dem Halbleitersubstrat (1), wobei die Wand (28) das Halbleitersubstrat (1) von der elektromagnetischen Energie im wesentlichen abschirmt, um eine Atmosphäre vorzusehen, die die reaktionsfähigen Arten enthält;
Ablösen des Resistmusters (3) in der Atmosphäre, die reaktionsfähige Arten enthält; und
Erhitzen des Substrates (1) in einem Vakuum bei einer Temperatur, die höher als 100 °C, aber niedrig genug ist, um einen Schaden an der Aluminiumlegierung zu vermeiden, wodurch die Restchlorkomponente von dem Substrat entfernt wird, welcher Erhitzungsschritt gleichzeitig mit dem Ablöseschritt oder nach dem Ablöseschritt ausgeführt wird.

2. Verfahren nach Anspruch 1, bei dem die Temperatur bei dem Erhitzungsschritt niedriger als etwa 400 °C ist.

3. Verfahren nach Anspruch 1 oder Anspruch 2, bei dem die reaktionsfähige(n) Art(en) aus einem Gemisch aus einem Fluorgas und Sauerstoffgas erzeugt wird (werden).

4. Verfahren nach einem der Ansprüche 1 bis 3, bei dem die reaktionsfähige(n) Art(en) aus einem Gemisch aus einem stickstoffhaltigen Gas und Sauerstoffgas erzeugt wird (werden).

5. Verfahren nach irgendeinem vorhergehenden Anspruch, bei dem die reaktionsfähige(n) Art(en) durch Erregung durch Mikrowellenenergie von etwa 2,45 GHz erzeugt wird (werden).

6. Verfahren nach irgendeinem vorhergehenden Anspruch, bei dem die Aluminiumlegierung eine Aluminium-Kupfer-Legierung ist.

**Revendications**

1. Procédé de formation d'un motif d'alliage d'aluminium sur un substrat semi-conducteur, comprenant les étapes suivantes :

la formation d'une couche d'un alliage d'aluminium (2) qui réagit avec le chlore pour la formation d'un composé chloré résiduel ayant une température de sublimation supérieure à celle du chlorure d'aluminium sur un substrat semi-conducteur (1) ayant une couche isolante,
la formation d'un motif (3) d'un matériau de réserve sur la couche (2) d'alliage d'aluminium,

l'attaque à sec d'une partie exposée de la couche (2) d'alliage d'aluminium avec un gaz contenant du chlore, choisi dans le groupe comprenant le chlore gazeux, le tétrachlorure de silicium gazeux, le trichlorure de bore gazeux et le tétrachlorure de carbone gazeux, à l'aide du motif (3) du matériau de réserve comme masque, si bien que la couche (2) d'alliage d'aluminium est mise sous forme de motif et le composé chloré résiduel reste sur le substrat,

la création d'un plasma dans un gaz à l'aide d'un gaz réactif contenant de l'oxygène gazeux par application d'énergie électromagnétique à une chambre (29) de création de plasma,

l'introduction d'une espèce réactive, créée dans le plasma, à partir de la chambre (29) de création de plasma par des trous formés dans une paroi (28) qui fait partie de la chambre génératrice de plasma, vers le substrat semi-conducteur (1), la paroi (28) protégeant essentiellement le substrat semi-conducteur (1) de l'énergie électromagnétique, pour la création d'une atmosphère contenant l'espèce réactive,

la séparation du motif (3) du matériau de réserve dans l'atmosphère contenant l'espèce réactive, et

le chauffage du substrat (1) sous vide à une température supérieure à 100 °C mais suffisamment faible pour éviter la détérioration de l'alliage d'aluminium, si bien que le composé chloré résiduel est chassé du substrat, l'étape de chauffage étant réalisée simultanément à l'étape de séparation ou après cette dernière étape.

2.  Procédé selon la revendication 1, dans lequel la température au cours de l'étape de chauffage est inférieure à 400 °C environ.

3.  Procédé selon la revendication 1 ou 2, dans lequel l'espèce réactive au moins est produite à partir d'un mélange d'un gaz fluoré et d'oxygène gazeux.

4.  Procédé selon l'une quelconque des revendications 1 à 3, dans lequel l'espèce réactive au moins est produite à partir d'un mélange d'un gaz contenant de l'azote et de l'oxygène gazeux.

5.  Procédé selon l'une quelconque des revendications précédentes, dans lequel l'espèce réactive est au moins produite par excitation par des hyperfréquences à 2,45 GHz environ.

6.  Procédé selon l'une quelconque des revendications précédentes, dans lequel l'alliage d'aluminium est un alliage d'aluminium-cuivre.

FIG. 1(a)

2 Al ALLOY LAYER

1 SUBSTRATE

FIG. 1(b)

3 PATTERNED RESIST

2

1

FIG. 1(c)

3

2' PATTERNED LAYER

1

FIG. 1(d)

2'

1

23 MICROWAVE-PASSING WINDOW

27 GAS INLET    30   REACTION CHAMBER    21 WAVEGUIDE

GAS IN

28 SHIELD

22 MICROWAVE

26

29 PLASMA GENERATION
CHAMBER

26 GAS OUTLET

25 STAGE

EXHAUST    31 HEATER    EXHAUST

1 SUBSTRATE

FIG. 2